(19) Europäisches Patentamt
European Patent Office
Office européen des brevets

(11) Publication number: **0 025 261**
**B1**

(12) **EUROPEAN PATENT SPECIFICATION**

(45) Date of publication of patent specification: **15.06.83**

(51) Int. Cl.³: **H 01 L 21/31**

(21) Application number: **80302337.3**

(22) Date of filing: **10.07.80**

(54) **A method of manufacturing a semiconductor device.**

(30) Priority: **31.07.79 JP 97655/79**

(43) Date of publication of application:
**18.03.81 Bulletin 81/11**

(45) Publication of the grant of the patent:
**15.06.83 Bulletin 83/24**

(84) Designated Contracting States:
**DE FR GB NL**

(56) References cited:
**FR - A - 2 188 304**
**GB - A - 1 523 677**
**US - A - 3 723 277**
**US - A - 4 029 562**

**Patents Abstracts of Japan Vol. 2, No. 124, 18—10—78, p. 7230E78 and the corresponding JPA 53—93366**

(73) Proprietor: **FUJITSU LIMITED**
**1015, Kamikodanaka Nakahara-ku**
**Kawasaki-shi Kanagawa 211 (JP)**

(72) Inventor: **Kurahashi, Toshio**
**925-A-403, Mamedo-cho Kohoku-ku**
**Yokohama-shi Kanagawa, 222 (JP)**
Inventor: **Tokitomo, Kazuo**
**260-12, Kitatakizawa Hachiman Itsukimachi**
**Aizuwakamatsu-shi Fukushima, 965 (JP)**
Inventor: **Kiriseko, Tadashi**
**3-6-16, Wakabadai Shiroyama-cho**
**Tsukiu-gun Kanagawa, 220-01 (JP)**

(74) Representative: **Bedggood, Guy Stuart et al,**
**Haseltine Lake & Co. Hazlitt House 28**
**Southampton Buildings Chancery Lane**
**London WC2A 1AT (GB)**

EP 0 025 261 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# A method of manufacturing a semiconductor device

This invention relates to a method of manufacturing a semiconductor device.

Semiconductor integrated circuits have achieved high degrees of integration as seen in large scale integrated circuits (LSI) or very large scale integrated circuits (VLSI), and to keep pace with such high degrees of integration conductive layers on the semiconductor substrates of such circuits are arranged in multiple layer structures. As a result, conductive layers and insulating layers are formed alternately one on the other, so that as the number of layers increases from two layers to three, for example, differences between the levels of layers increase.

If a difference between the levels of layers is great, it frequently tends to cause problems such as disconnection or short-circuiting of conductors.

Means for minimizing such level differences have been studied, and one method has been applied in which, after formation of a conductive layer in accordance with a given pattern therefor, a liquid glass is applied to cover the entire surface of the conductive layer and is then hardened, whereafter a layer of phosphosilicate glass (PSG) is caused to adhere on the surface of the hardened liquid glass.

The liquid glass mentioned above is a liquid of which main component is silicic acid made through hydrolysis of methylsilicate which in turn is hardened when treated at high temperature to form an insulator of which main component is silicon dioxide as will be understood from the following:

$$Si(OCH_3)_4+4H_2O \rightarrow Si(OH)_4+4CH_3OH$$

$CH_3OH$ evaporates when heated and

$$Si(OH)_4 \rightarrow SiO_2+2H_2O$$

in which $H_2O$ also evaporates.

Now, a film of silicon dioxide obtained by hardening of the liquid glass has a thermal expansion coefficient substantially different from that of a conductive layer of for example aluminium, so that the silicon dioxide film is susceptible to cracking where it is in contact with the conductive layer. The greater the thickness of the film, the greater the possibility of cracking.

To assist in further explanation reference will be made to Fig. 1 of the accompanying drawings which is a cross-sectional view of a part of a semiconductor substrate with a conductive layer and an insulator layer formed thereon by a previously proposed method.

If there are cracks in a silicon dioxide film, when a window is opened as shown in Fig. 1 for the purpose of forming a connection for terminal pads, an etchant in liquid form which is used to open the window will permeate into the cracks. It is difficult to remove such etchant, and this gives rise to problems such as corrosion of the conductor layers and detachment of the PSG layer. This is a defect fatal to the reliability of the semiconductor device as a whole.

In Fig. 1, there is shown a substrate 1, a conductive layer 2, a film 3 of silicon dioxide formed by hardening a liquid glass, and a PSG layer 4 on the substrate. Cracks are seen at the interface of the conductive layer 2 and the film of oxidised silicon 3.

Although there are some variations due to differences in viscosity, a liquid such as liquid glass mentioned above generally tends to spread and adhere thinly on upper surfaces of protrusions such as conductive layers and to adhere thickly in indented or depressed regions between conductive layers. In spite of this, great care has been devoted to spreading the liquid thinly so that the glass layer has a thickness in the order of 500 to 2000 Å to avoid formation of cracks.

However, it goes against the desired object of minimizing differences of level as much as possible to so form a thin layer of liquid glass and, naturally, to do so does little toward making the surface flat.

FR—A—2 188 304 discloses a method of manufacturing a semiconductor device having a layer structure of a silicon substrate. The layer structure comprises metallic contacts and an insulating layer, advantageously of silica, is formed on the upper surfaces of the metallic contacts and on the substrate. A material may be interposed between the insulating layer and the upper surfaces of the metallic contacts. The interposed material may advantageously be the resin employed in the etching of the metallic contacts. That etching may be effected by a photoetching process using a mask. By thermal cracking (craquage thermique) of the interposed material the insulating layer can be removed from above the metallic contacts.

GB—A—1 523 677 discloses a method of manufacturing a semiconductor device having a layer structure on a semiconductor substrate. A $SiO_2$ insulating layer is formed on the semiconductor substrate. A resist layer is formed on the $SiO_2$ insulating layer and acts as a mask for etching of the $SiO_2$ insulating layer. V-shaped grooves are formed in the insulating layer by the etching and the resist layer overhangs the V-shaped grooves. Aluminium is then evaporated on for forming a wiring layer. Non-connected portions of aluminium are formed in the V-shaped grooves and on the resist layer. Due to the overhanging of the resist layer a part of the overhanging resist is uncovered by the aluminium. The resist layer is removed, together with the aluminium of the resist layer, by use of

a resist layer stripping agent. A liquid insulating material (a liquid containing particles of silica: liquid silica) is then coated by a spinner method onto the insulating layer and the wiring layer. The coating is then burnt at 220° for 10 minutes in air. A silica layer is thus formed.

US—A—3 723 277 discloses a process in which a photoresist mask is produced on a semiconductor substrate. A silicon oxide-coat is produced on the photoresist and on the substrate by cathodic sputtering in a gas discharge. The sputtering is initially carried out at a relatively low power density. Power density is then increased to effect partial decomposition of the photoresist mask to tear open the superposed previously hermetically tight silicon oxide-coat. Solvent is thereafter applied to effect swelling of undecomposed portions of the photoresist mask and tearing of the borders of the superposed silicon oxide-coat. Ultrasonic treatment is then used to remove the residues of the mask and the superposed oxide-coat.

In Patent Abstracts of Japan, volume 2, No. 124, October 18th 1978, page 7230 E 78, relating to JP—A—53—93366, the heating of a silicon substrate to a temperature of over 140°C, to deform a photoresist film on the substrate is disclosed.

According to the present invention there is provided a method of manufacturing a semiconductor device, comprising the steps of:—

forming a film of photoresist over a selected upper surface region of a layer structure on a semiconductor substrate;
applying an insulating layer to cover the film of photoresist and the upper surfaces of the layer structure;
and removing the film of photoresist, simultaneously lifting off and removing insulating layer parts on the photoresist film;

characterised by the steps of:

applying a liquid glass for forming the insulating layer;
baking the substrate at a sufficiently high temperature to harden the liquid glass and deform and shrink the film of photoresist thereby to expose sides of the film of photoresist;
and thereafter removing the film of photoresist to simultaneously remove hardened liquid glass on the film of photoresist by lifting off hardened liquid glass on the film of photoresist.

In an embodiment of the present invention the problems referred to above in connection with previous proposals for minimizing differences of level between various layers formed on the surface of a semiconductor substrate are eliminated by a method in which hardened liquid glass is completely eliminated from the upper surface of a conductive layer, and in which a good thickness of liquid glass is provided in areas between conductive layers.

In an embodiment of the present invention a film of photoresist is formed in advance on a region from whence a layer of liquid glass is to be removed, the surface of the film is covered with a liquid glass which is caused to hardened, and then, by removing the film of photoresist, the hardened liquid glass on the film is simultaneously removed by lifting off.

Reference is made, by way of example, to the accompanying drawings, in which:—

Fig. 1, as mentioned above, is a cross-sectional view of a part of a semiconductor substrate with a conductive layer and an insulator layer formed thereon by a previously proposed method, and

Fig. 2A to Fig. 2E are respective cross-sectional views illustrating successive steps in a method embodying the present invention.

In Fig. 2A, a semiconductor substrate 11 is shown with a layer 12 of aluminium conductor of a thickness of approximately 1 μm patterned thereon. A film 10 of photoresist used as a mask for etching at the time of patterning of the conductor layer is left where it is without being removed.

Next, as seen in Fig. 2B, a liquid glass 13 is applied, by using a conventional spinner for example, and the substrate 11 is then baked at a temperature within the range 170°C to 200°C. So much of the liquid glass is applied that, after said baking, the thickness of a film forms from the liquid glass in an indented or depressed region between conductor layers 12 is of the order of up to several thousand Å.

Thereafter, the substrate 11 is further baked at high temperatures within the range 450°C to 500°C. The photoresist film 10 is thereby caused to deform and shrinks as illustrated in Fig. 2C, with hardened liquid glass 13 thereon dragged in to expose sides of the photoresist film parts on the conductor layers 12.

Then, the photoresist film 10 is removed by a solution containing organic solvent for separating the film from the conductor layers 12. If any resist remains it will be turned into ashes by oxygen plasma and removed.

Thereupon, as shown in Fig. 2D, the parts of the hardened liquid glass 13 on the photoresist film 10 formed on the upper surfaces of aluminium conductor layers 12 is also removed simultaneously with the removal of the photoresist film 10 by lift off, and the liquid glass is completely eliminated from the upper surfaces of the conductor layers of aluminium.

After these steps are completed a layer 14 of PSG of a thickness of approximately 1 μm is formed to cover the formation on the substrate by conventional chemical vapour deposition, and a window is opened for a terminal pad connection as seen in Fig. 2E.

There will be no liquid glass 13 on the aluminium conductor layers 12 and no cracks. Because of this, there will be no problems of

corrosion of conductors due to cracks formed at the time of opening of windows for the contact of a second wiring conductive layer with the layers 12 and for the purpose of bonding of lead wires thereto.

One embodiment of the present invention has so far been described, but the present invention may be applied widely for the purpose other than the one already described because a film of photoresist may be formed on any surface susceptible to cracking, and liquid glass on the upper surface of the photoresist film may be removed by lift off, allowing a thick film of liquid glass to be formed on the surfaces of parts which have a small expansion coefficient, such as a semi-conductor substrate.

As has been described, it is possible to apply liquid glass thickly by means of the present invention, so that the method of the invention serves the purpose of making the surface of a layer structure on a semi-conductor substrate much flatter. That is, the method of the present invention facilitates the formation of multiple layer wiring conductors in a semiconductor integrated circuit device.

The method of the invention is valuable for application to integrated circuits of a high packing density, such as LSI devices, and is effective in increasing the reliability of the product.

A method of manufacturing a semiconductor device embodying this invention comprises the steps of applying liquid glass to cover the upper surfaces of a semi-conductor device and patterning, a film of photoresist is formed in advance on a region from which the layer of liquid glass is to be removed, the liquid glass is applied to cover the upper surface of the film and is caused to be hardened, and thereafter, by removing the photoresist film, the hardened glass on the photoresist is removed simultaneously by lift off.

## Claims

1. A method of manufacturing a semiconductor device, comprising the steps of:—

forming a film of photoresist over a selected upper surface region of a layer structure on a semiconductor substrate;

applying an insulating layer to cover the film of photoresist and the upper surfaces of the layer structure;

and removing the film of photoresist, simultaneously lifting off and removing insulating layer parts on the photoresist film;

characterised by the steps of:

applying a liquid glass for forming the insulating layer;

submitting the substrate to a baking process at sufficiently high temperatures to harden the liquid glass and further to deform and shrink the film of photoresist thereby to expose sides of the film of photoresist;

and thereafter removing the film of photoresist to simultaneously remove hardened liquid glass on the film of photoresist by lifting off hardened liquid glass on the film of photoresist.

2. A method as claimed in claim 1, wherein the liquid glass is applied and the substrate baked, at a temperature between 170°C and 200°C, such that the thickness of the insulating layer which is formed is of the order of several thousand Å, and wherein the substrate is further baked at a temperature in the range from 450°C to 500°C, prior to the step of removing the film of photoresist, to harden the liquid glass and to deform and shrink the film of photoresist.

3. A method as claimed in claim 2, wherein the film of photoresist is removed by etching.

4. A method as claimed in any preceding claim, wherein the film of photoresist is formed over the upper surface region of a conductive layer of the layer structure.

5. A method as claimed in claim 4, comprising a further step of forming a film of phospho-silicate glass to cover the upper surface region of the conductive layer from which the hardened liquid glass has been removed.

## Revendications

1. Procédé de fabrication d'un dispositif à semi-conducteurs, comprenant les phases:

de formation d'un film photosensible sur une région de surface supérieure sélectionnée d'une structure de couche sur un substrat semi-conducteur;

d'application d'une couche isolante pour couvrir le film photosensible et les surfaces supérieures de la structure de couche;

et d'élimination du film photosensible, simultanément avec le soulèvement et l'élimination de parties de couche isolante sur le film photosensible;

caractérisé par les phases:

d'application d'un verre liquide pour former la couche isolante;

de soumission du substrat à un processus de cuisson à des températures suffisamment élevées pour durcir le verre liquide et en outre pour déformer et contracter le film photosensible afin d'exposer des côtés du film photosensible;

et ensuite d'élimination du film photosensible pour éliminer simultanément le verre liquide durci sur le film photosensible par soulèvement du verre liquide durci sur le film photosensible.

2. Procédé selon la revendication 1, dans lequel le verre liquide est appliqué et le substrat chauffé à une température entre 170°C et 200°C, de manière que l'épaisseur de la couche isolante qui est formée soit de l'ordre de quelques milliers de Å, et dans lequel le substrat est ensuite chauffé à une température dans la plage de 450°C à 500°C avant la phase d'élimination du film photosensible; pour durcir le verre liquide et pour déformer et contracter le film photosensible.

3. Procédé selon la revendication 2, dans lequel le film photosensible est éliminé par attaque chimique.

4. Procédé selon l'une quelconque des revendications précédentes dans lesquelles le film photosensible est formé sur la région de surface supérieure d'une couche conductrice de la structure de couche.

5. Procédé selon la revendication 4, comprenant une autre phase de formation d'un film de verre au phospho-silicate pour couvrir la région de surface supérieure de la couche conductrice de laquelle le verre liquide durci a été éliminé.

**Patentansprüche**

1. Verfahren zur Herstellung einer Halbleitervorrichtung, bei welchem

ein Film aus Fotoresist auf einem ausgewählten oberen Oberflächenbereich einer Schichtstruktur auf einem Halbleitersubstrat ausgebildet wird,
eine isolierende Schicht aufgebracht wird, um den Film aus Fotoresist und die oberen Oberflächen der Schichtstruktur zu überdecken,
und der Film aus Fotoresist entfernt wird, wobei gleichzeitig mit dem Abheben die isolierenden Schichtabschnitte auf dem Fotoresistfilm entfernt werden,

dadurch gekennzeichnet,

daß flüssiges Glas aufgebracht wird, um eine isolierende Schicht zu bilden,
daß das Substrat einem Back-Prozeß bei hinreichend hohen Temperaturen unterworfen wird, um das flüssige Glas zu härten und um ferner den Film aus Fotoresist zu verformen und zu schrumpfen, um dadurch die Seiten des Fotoresistfilms zu exponieren,
und daß danach der Fotoresistfilm entfernt wird, um gleichzeitig das gehärtete flüssige Glas auf dem Fotoresistfilm durch Abheben des auf dem Fotoresist gehärteten flüssigen Glases zu entfernen.

2. Verfahren nach Anspruch 1, dadurch gekennzeichnet, daß das flüssige Glas aufgebracht und das Substrat bei Temperaturen zwischen 170°C und 200°C gebacken wird, so daß die Dicke der isolierenden Schicht, welche gebildet wird, in der Größenordnung von mehreren tausend Å ist, und daß das Substrat ferner, vor Entfernung des Fotoresistfilms, bei einer Temperatur im Bereich zwischen 450°C und 500°C gebacken wird, um das flüssige Glas zu härten und um den Fotoresistfilm zu verformen und zu schrumpfen.

3. Verfahren nach Anspruch 2, dadurch gekennzeichnet, daß der Fotoresistfilm durch Ätzung entfernt wird.

4. Verfahren nach einem der vorhergehenden Ansprüche, dadurch gekennzeichnet, daß der Fotoresistfilm über dem Oberen Oberflächenbereich einer Leiterschicht der Schichtstruktur ausgebildet wird.

5. Verfahren nach Anspruch 4, dadurch gekennzeichnet, daß ferner ein Film aus Phosphosilikatglas ausgebildet wird, um den oberen Oberflächenbereich der leitenden Schicht, von welcher das gehärtete flüssige Glas entfernt worden ist, zu bedecken.

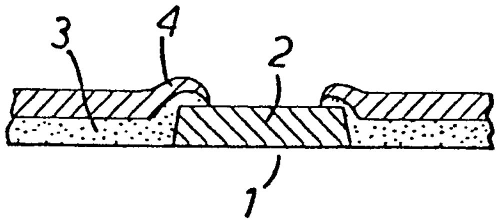


FIG. 1.

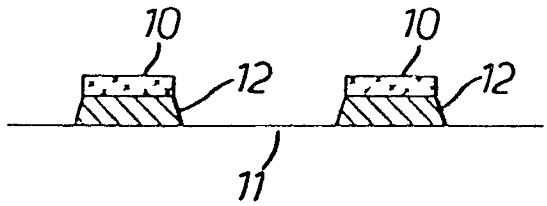


FIG. 2A.

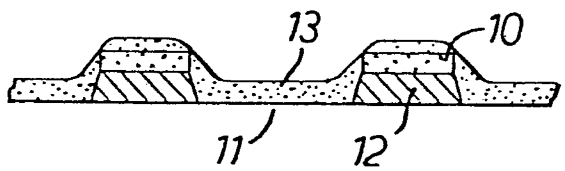


FIG. 2B.

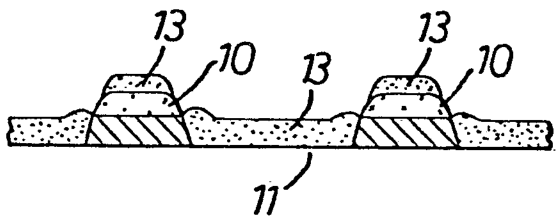


FIG. 2C.

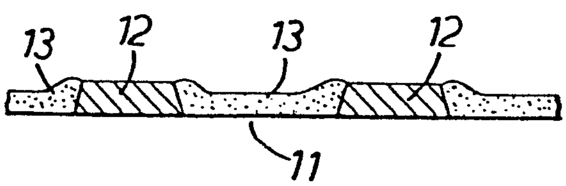


FIG. 2D.

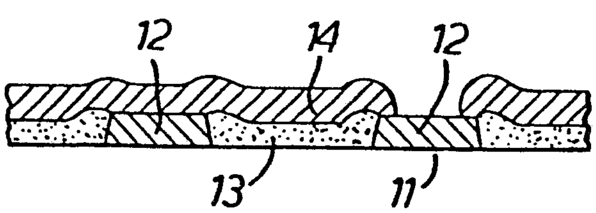


FIG. 2E.